# EUROPEAN PATENT SPECIFICATION

(11) **EP 1 752 989 B1**
(45) Date of publication and mention of the grant of the patent: **23.04.2008**
(21) Application number: 05106976.3
(22) Date of filing: 28.07.2005
(51) Int. Cl.: G11C 16/32, G11C 16/26, G11C 16/34

(54) **NAND flash memory with erase verify based on shorter delay before sensing**
NAND Flash Speicher mit Löschprüfung basierend auf einer kürzeren Verzögerung vor dem Sensing
Mémoire Flash NAND avec vérification d'effacement ayant un plus court délai avant l'amplification

(43) Date of publication of application: 14.02.2007
(73) Proprietor: STMicroelectronics S.r.l., 20041 Agrate Brianza (Milano) (IT); Hynix Semiconductor Inc., Ichon-si, Kyoungki-do 467-701 (KR)
(72) Inventor: Bovino, Angelo, 39031 Brunico (BZ) (IT); Micheloni, Rino, 22078 Turate (CO) (IT); Ravasio, Roberto, 24036 Ponte San Pietro (BG) (IT)
(74) Representative: Pezzoli, Ennio

(56) References cited:
- EP-A- 1 164 597
- US-A- 5 864 503
- US-A- 5 933 366
- US-A1- 2003 156 478
- US-B1- 6 304 486

## Description

### Field of the invention

The present invention relates to the field of non-volatile memory devices. More specifically, the present invention relates to the reading of a non-volatile memory device.

### Background art

Non-volatile memory devices are used in a number of applications, whenever data must be retained even if a power supply is off. Flash memories are a particular type of non-volatile memory devices, in which each cell can be electrically programmed, but a large number of cells (which form a sector) must be erased at the same time. Typically, each cell is formed by a floating gate MOS transistor that stores a logic level defined by its threshold voltage (which depends on the electric charge stored in the corresponding floating gate). In particular, in a flash memory device with NAND architecture the cells are arranged in strings, each one consisting of a set of cells connected in series. The main advantage of this architecture is the reduced area occupation (essentially due to the low number of electrical contacts and to the small size of the cells). This makes the NAND memory devices particularly advantageous in a number of applications (for example, for memory cards).

Typically, the cells of the NAND memory devices are read bv comparing their threshold voltages with suitable reference voltages (as described, for example, in US-B-6304486 and US-A-5933366).

In order to further reduce the complexity of the NAND memory devices, the cells of a selected sector are generally erased by applying a single blind erasing pulse, which is dimensioned so as to lower their threshold voltages below a reference reading voltage (typically, 0V). Moreover, the NAND memory devices implement a decoding system that is able to bias the various cells selectively with positive voltages only (i.e., equal or higher than zero).

A problem of the NAND memory devices is due to the capacitive coupling between the floating gates of adjacent cells; such effect makes the threshold voltage of each cell depending on the electric charge stored in the floating gates of the adjacent cells.

The capacitive coupling effect modifies the threshold voltage of each cell whenever the adjacent cells are programmed. The suffered variation increases with the increment of the threshold voltages of the adjacent cells during the programming operation. Thus, the problem is particularly serious when the adjacent cells to be programmed start from very low threshold voltages. As a result, this variation may cause errors during the reading operations.

In order to limit the capacitive coupling effect, it would be desirable to increase the threshold voltages of the erased cells; for example, it is possible to shift the threshold voltages of the erased cells by applying a soft programming pulse (of reduced amplitude and duration). However, after this operation it is necessary to verify that the cells are still erased. For this purpose, the cells should be read with respect to the reading voltage with a negative margin (so as to ensure that they are not approaching the reading voltage beyond a safety limit).

The above-described operation requires the biasing of the cells to be read with a negative voltage (so as to make it possible to discriminate whether their threshold voltages are actually lower than the desired value). Therefore, this operation is inherently incompatible with the structure of the NAND memory devices known in the art (wherein only a positive decoding system is available).

### Summary of the invention

The present invention proposes a solution, which is based on idea of emulating multiple reference voltages during a reading operation by using different reading times. The non-volatile memory device of the invention is defined by claim 1.

In a preferred embodiment of the invention, a shorter delay is used.

Advantageously, the second biasing voltage is equal to the first reference voltage.

In a further embodiment of the invention, the selected cells are read with respect to a third reference voltage by applying a third biasing voltage (different from the second biasing voltage), but using the same delay.

Preferably, each biasing voltage has a predefined sign (such as positive) or a null value, while the second and/or the third reference voltage has the opposite sign (such as negative).

Typically, the first reference voltage is a reading voltage (such as 0V), the second reference voltage is the reading voltage with a margin (such as -1V) and the third reference voltage is the reading voltage with a lower margin (such as -0.5V).

In a preferred embodiment of the invention, the proposed solution is used for soft-programming the erased cells so as to shift their threshold voltages towards the reading voltage until they reach the second reference voltage (*i.e.,* -1V).

The proposed solution is preferably applied to a non-volatile memory device with NAND architecture.

As a further enhancement, it is verified that the threshold voltages of the soft-programmed cells are still lower than the third reference voltage (*i.e*., -0.5V).

Another aspect of the present invention provides a corresponding method for reading a non-volatile memory device, as defined by claim 10.

The characterizing features of the present invention are set forth in the appended claims. The invention itself, however, as well as further features and the advantages thereof will be best understood by reference to the following detailed description, given purely by way of a non-restrictive indication, to be read in conjunction with the accompanying drawings.

### Brief description of the drawings

**Figure 1** is a schematic block diagram of a memory device in which the solution according to an embodiment of the invention can be used;
**Figure 2A** details a portion of the memory device;
**Figure 2B** shows exemplificative time diagrams relating to operation of this portion of the memory device;
**Figure 3** shows illustrative time diagrams explaining the principle on which the solution according to an embodiment of the present invention is based;
**Figure 4** shows a flow chart describing an erasing procedure of the memory device according to an embodiment of the present invention; and
**Figures 5A** through **5D** are exemplificative representations of various distributions of the threshold voltages of the erased cells according to an embodiment of the present invention.

### Detailed description

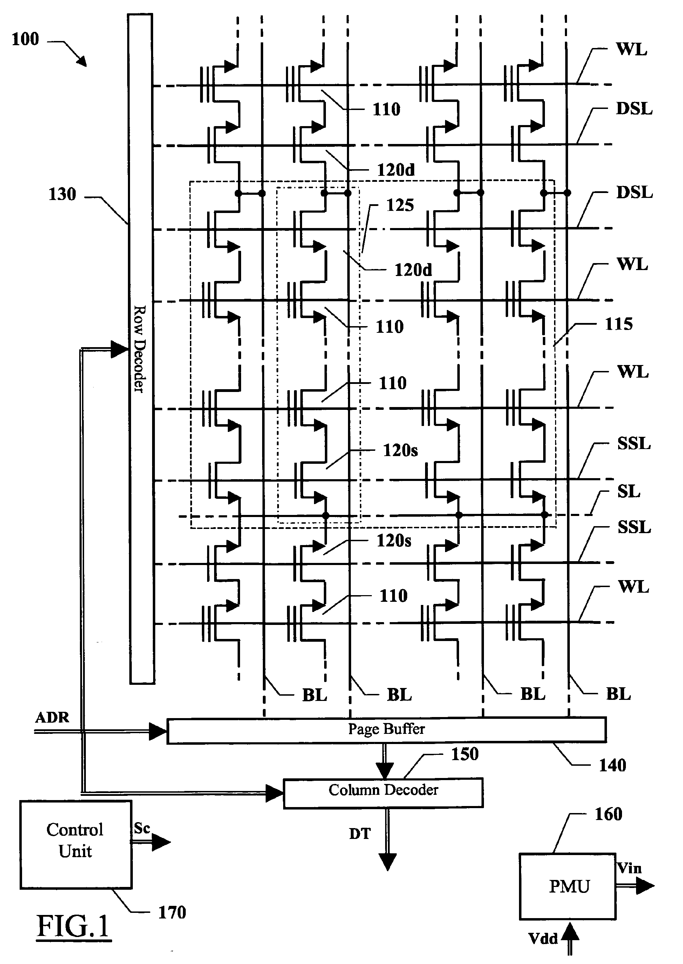

With reference in particular to **Figure 1****,** a non-volatile semiconductor memory device of the flash type **100** is shown. The memory device **100** includes a matrix of cells **110,** typically realized by floating-gate MOS transistors. The matrix includes one or more sectors **115,** each one being individually erasable; in particular, all the cells **110** are formed in a common body region of a chip of semiconductor material (wherein the memory device **100** is integrated).

In an erased condition each cell **110** has a low threshold voltage (to which a logic level "1" is typically associated). The cell **110** is programmed by injecting electrons into its floating-gate; in this condition the cell **110** has a high threshold voltage (to which a logic level "0" is typically associated). Therefore, when the cell **110** is biased for reading, it is conductive if erased or it is non-conductive if programmed.

The cells **110** are arranged in a plurality of rows and columns. The memory device **100** is of the **NAND** type. In this architecture, each sector **115** includes a plurality of strings **125;** each string **125** is formed by a set of cells **110** (typically 16) that are connected in series between two select transistors **120s** and **120d.**

In detail, an intermediate cell **110** of the string **125** has the drain terminal connected to the source terminal of the upper cell **110** and the source terminal connected to the drain terminal of the lower cell **110.** The lowest cell **110** of the string **125** has the source terminal connected to the drain terminal of the select transistor **120s,** while the uppermost cell **110** of the string **125** has the drain terminal connected to the source terminal of the select transistor **120d.** Moreover, the select transistor **120s** has the source terminal connected to the source terminal of the select transistor **120s** of a lower string and the transistor **120d** has the drain terminal connected to the drain terminal of the select transistor **120d** of an upper string. The gate terminals of the cells **110** of each row are connected to a corresponding word line **WL.** The drain terminals of the select transistors **120d** of the strings of each column are connected to a corresponding bit line **BL.** The gate terminals of the select transistors **120d** positioned on a same row are connected to a corresponding drain select line **DSL;** likewise, the gate terminals of the select transistors **120s** positioned on a same row are connected to a corresponding source select line **SSL.** Moreover, the source terminals of all the select transistors **120s** are connected to a common source line **SL,** which is typically maintained at a reference voltage (or ground).

The cells **110** belonging to each row are logically grouped in two pages; in detail, a first page is formed by the cells **110** having an even position and a second page is formed by the cells having an odd position. The memory device **100** receives an address **ADR** for selecting a desired page. A portion of the address **ADR** is supplied to a row decoder **130** that selects the word line **WL** of the desired page, and the drain select line **DSL** and the source select line **SSL** of the corresponding strings **125.** Another portion of the address **ADR** (1 bit) is supplied to a page buffer **140.** The page buffer **140** selects the bit lines **BL** of the desired page, that is, the even ones or the odd ones; the page buffer **140** then reads (or writes) the cells **110** of the selected page. The page buffer **140** interfaces with a column decoder **150;** the column decoder **150** receives a further portion of the address **ADR,** and outputs a corresponding word **DT** selected in the page that has been read by the page buffer **140.**

The memory device **100** further includes a power management unit (**PMU**) **160** and a control unit **170.** The PMU **160** supplies the voltages that are used for performing the various operations on the memory device **100,** for example, from approximately 0V to approximately 20V (referred to as a whole with **Vin**); the voltages **Vin** are generated (for example, through charge pumps) starting from a power supply voltage **Vdd** supplied from the outside (typically, 1.8/3V). The control unit **170** provides the control signals (referred to as a whole with **Sc)** that are used for driving the various components of the memory device **100.**

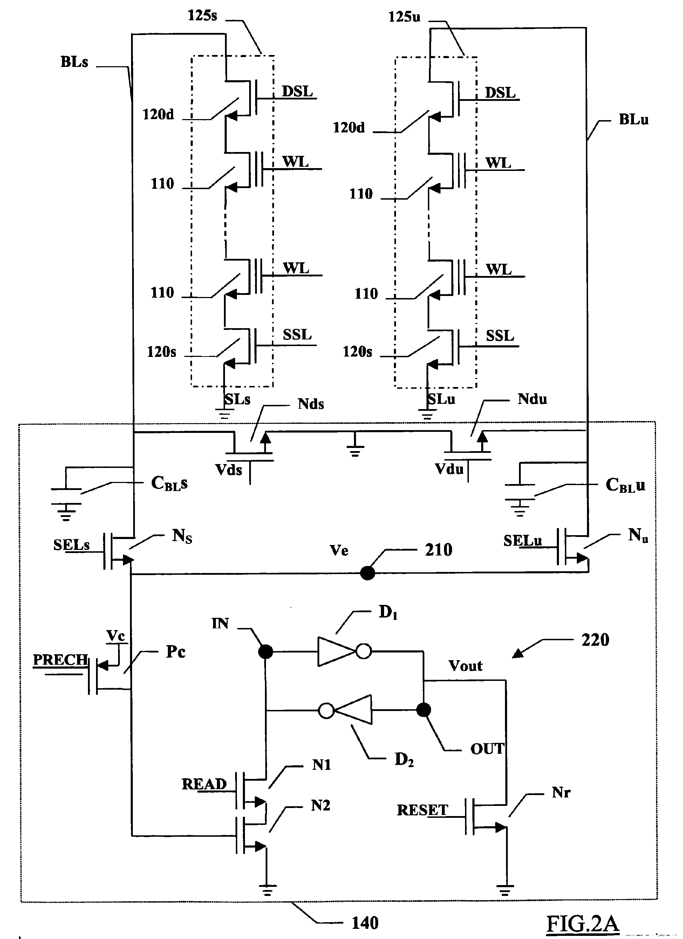

Referring to **Figure 2A****,** a more detailed representation of a portion of the above described memory device is shown. Particularly, the page buffer **140** includes a read unit for each pair of (even and odd) bit lines (the components used for writing the selected cells are omitted for sake of simplicity). Particularly, a selected string is denoted with **125s** and an unselected string is denoted with **125u** (from now on, the suffixes "s" and "u" will be added to the references of the circuital components to discriminate the ones associated with the selected string **125s** from the ones associated with the unselected string **125u**). The strings **125s** and **125u** have the source lines **SLs** and **SLu** connected to a ground terminal.

Two NMOS transistors **Ndu** and **Nds** are used for discharging the bit lines **BLu** and **BLs,** respectively. In particular, the NMOS transistors **Ndu** and **Nds** have the source terminal and the drain terminal, respectively, that are connected together to the ground terminal. Moreover, the NMOS transistor **Nds** has the drain terminal connected to the bit line **BLs,** whereas the NMOS transistor **Ndu** has the source terminal connected to the bit line **BLu.** The NMOS transistors **Nds** and **Ndu** receive at their gate terminals discharging voltages **Vds** and **Vdu,** respectively.

Two further NMOS transistors **Ns** and **Nu** have the drain terminals connected to the bit lines **BLs** and **BLu,** respectively, and the source terminals connected to a common node **210** (providing an evaluation voltage **Ve**); the gate terminals of the NMOS transistors **Ns** and **Nu** receive a select signal **SELs** and a further select signal **SELu=SELs** respectively, (corresponding to the relevant bit of the received address). The stray capacitances of the bit lines **BLs** and **BLu** are represented by corresponding capacitors **C_{BL}s** and **C_{BL}u**, connected between the drain terminal of the NMOS transistor **Ns** and **Nu,** respectively, and the ground terminal.

The page buffer **140** includes a PMOS transistor **Pc** that is used to pre-charge the node **210** at the beginning of the reading operation. The transistor **Pc** has the drain terminal connected to the node **210** and the source terminal connected to a terminal providing a pre-charging voltage **Vc** (for example, 2.1V). The gate terminal of the PMOS transistor **Pc** receives a pre-charging signal **PRECH** (from the Control Unit); the pre-charging signal **PRECH** is underlined to denote that it is asserted at the low logic level (for example, ground) and deasserted at the high logic level (for example, **Vdd).**

The page buffer **140** further includes a latch **220** that is used to read the logic level stored in the selected cell **110.** More in detail, the latch **220** is formed by two inverters **D1** and **D2.** The input terminal of the inverter **D1** and the output terminal of the inverter **D2** are connected together to define an input node **IN** of the latch **220;** likewise, the output terminal of the inverter **D1** and the input terminal of the inverter **D2** are connected together to define an output node **OUT** of the latch **220,** which provides an output signal **Vout** (representing the read logic level). An NMOS transistor **Nr** is used to reset the latch **220.** For this purpose, the transistor **Nr** has the drain terminal connected to the output node **OUT** and the source terminal connected to the ground terminal; the gate terminal of the NMOS transistor **Nr** is controlled by a reset signal **RESET** (from the Control Unit).

The latch **220** is set by means of two NMOS transistors **N1** and **N2** that are connected in series. Particularly, the NMOS transistor **N1** has the drain terminal connected to the input node **IN** and the source terminal connected to the drain terminal of the NMOS transistor **N2;** the source terminal of the NMOS transistor **N2** is connected to the ground terminal. The gate terminal of the NMOS transistor **N2** is controlled by the voltage at the node **210,** while the gate terminal of the transistor **N1** is controlled by a latching signal **READ** (from the Control Unit).

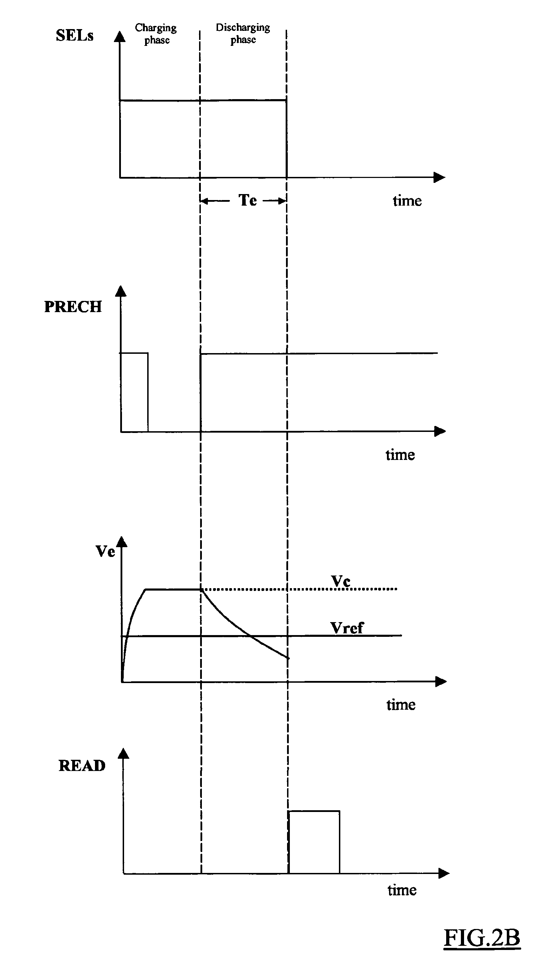

In **Figure 2B** there are shown the signals **SEL, PRECH, Ve** and **READ,** over time.

Considering now **Figures 2A** and **2B** together, a reading operation of a selected cell **110** of the string **125s** will be described. Before starting this operation, the reset signal **RESET** is brought to the high logic level so as to switch on the NMOS transistor **Nr** (thereby bringing the output node **OUT** to ground); as a result, the latch **220** is reset and the output signal **Vout** reaches the low logic level.

During the reading operation the select signal **SELu** at the low logic level switches off the NMOS transistor **Nu** so as to maintain the string **125u** always disconnected. At the same time, the control signal **SELs** at the high logic level switches on the NMOS transistor **Ns** (so as to connect the bit line **BLs** of the selected string **125s** to the node **210**).

At the beginning of a charging phase the pre-charging signal **PRECH** is asserted so as to switch on the PMOS transistor **Pc** (while the select transistors **120s** and **120d** remain off). In such a way, the bit line **BLs** *(i.e.,* the capacitor **C_{BL}s** ) is charged to the pre-charging voltage **Vc** (2.1V). The charging phase has a length (for example, ranging from approximately 3µs to approximately 5 µs) ensuring that the evaluation voltage **Ve** at the node **210** has reached the precharging voltage **Vc** (apart from the voltage drop at the NMOS transistor **Ns**).

Subsequently, during a discharging phase, the pre-charging signal **PRECH** switches to the high logic level (in such a way, the PMOS transistor **Pc** turns off). The (drain and source) select lines **DSL** and **SSL** of the strings corresponding to the selected page are brought to the supply voltage **Vdd** (1.8/3V); in this way, the corresponding select transistors **120d** and **120s** switch on. At the same time, the word line **WL** of the selected page is brought to a reference reading voltage **V_{R}** (for example, **V_{R} =** 0V) comprised between the threshold voltage of the erased cells and of the programmed cells; the other word lines **WL** of those strings are brought to a closing voltage Vpass (for example, 5V) so that the corresponding cells **110** are always conductive (irrespective of their threshold voltages). When the selected cell **110** is programmed it is not conductive (since its threshold voltage is higher than the reading voltage **V_{R}**); therefore, the evaluation voltage **Ve** of the node **210** remains at the value **Vc** (denoted with a dotted line in the Figure). Vice versa, when the selected cell **110** is erased it is conductive (since its threshold voltage is lower than the reading voltage **V_{R}**); therefore, the capacitor **C_{BL}s** discharges towards ground.

The latching signal **READ** is brought at the high logic level at the end of an evaluation time **Te** (for example, 10µs), which is substantially longer than the length of the above mentioned discharging process. The signal **READ** at the high logic level switches on the transistor **N1.** If the evaluation voltage **Ve** is at the high logic level (selected cell **110** programmed), the NMOS transistor **N2** is on as well so that the input node **IN** is brought the low logic level (because both the transistors **N1** and **N2** are conductive); as a result, the latch **220** is set and the output signal Vout switches to the high logic level. Conversely, if the selected cell **110** is erased the evaluation voltage **Ve** is lower than a comparing voltage **Vref** (consisting of the threshold voltage of the transistor **N2,** such as 1.3V), so that the NMOS transistor **N2** is not conductive; in this case, the input node **IN** remains at the high logic level and the output signal **Vout** remains at the low logic level.

The inventors have recognized that it is possible to read the selected cell **110** with respect to a different reference voltage (for example, with a negative value) by simply changing the length of the evaluation time **Te** (for the same biasing of the selected word line **WL**).

Indeed, the discharging time of the selected bit line **BLs** (when the selected cell **110** is erased) depends on the resistance of the selected cell **110,** which in turn depends on its threshold voltage.

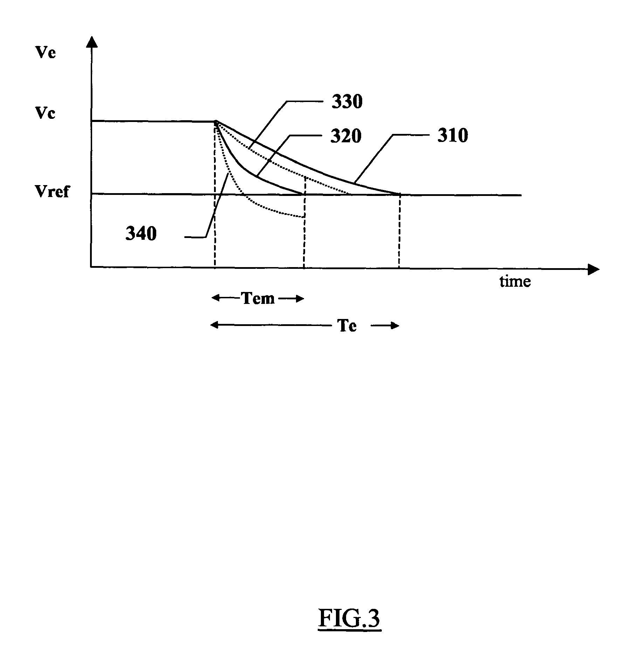

For example, as shown in the **Figure 3****,** a discharge curve **310** of a selected cell having a threshold voltage exactly equal to the reading voltage **V_{R}** (0V) reaches the comparing voltage **Vref** at the end of the evaluation time **Te.** If the selected cell has a lower threshold voltage (for example, -1V) it is more conductive; therefore, the selected bit line **BLs** discharges in a shorter time (so as to reach the comparing voltage **Vref** in advance), as shown by the discharge curve **320.**

As a result, it is possible to read the selected cell with respect to a different reference voltage **(V_{Rm}=-1V)** by using an evaluation time **Tem (Tem<Te)** corresponding to the intersection of the discharge curve **320** with the line **Ve=Vref.**

Indeed, if the selected cell has a threshold voltage higher than the reference voltage **V**_{Rm} (discharge curve **330),** at the end of the evaluation time **Tem** the evaluation voltage **Ve** will be higher than the comparing voltage **Vref** (and the output voltage **Vout** is at the low logic level), whereas if the selected cell has a threshold voltage lower than the reference voltage **V_{Rm}** (discharge curve **340),** at the end of the evaluation time **Tem** the evaluation voltage **Ve** will be lower than the comparing voltage **Vref** (and the voltage **Vout** is at the high logic level).

In this way, it is possible to read the selected cell with respect to any desired negative reference voltage by applying a null (or positive) biasing voltage to the selected word line.

For example, this feature can be exploited for shifting the threshold voltages of the erased cells towards less negative values.

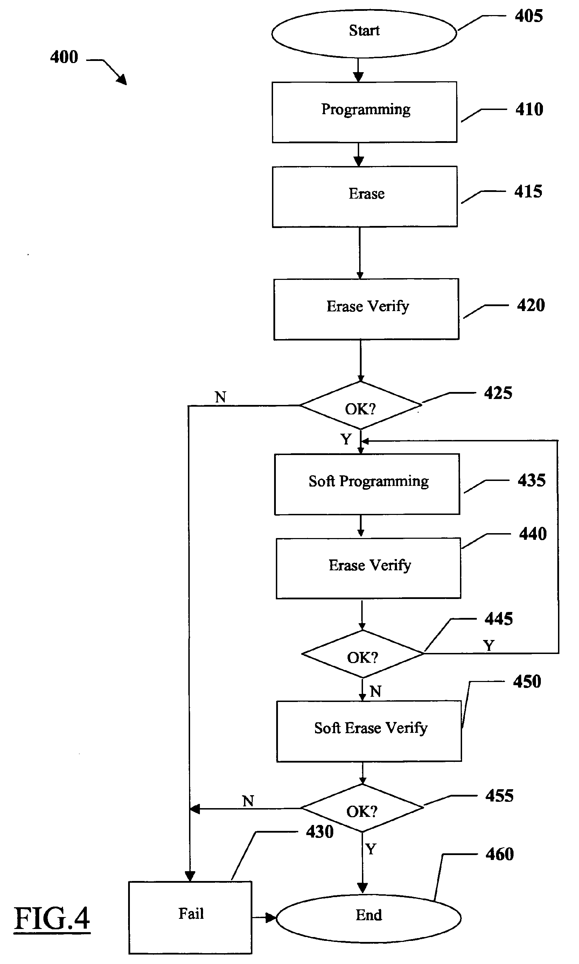

Referring now to **Figure 4****,** there is represented a method **400** that discloses an erasing algorithm of a selected sector of cells according to an embodiment of the invention. The method **400** starts at the block **405** and then moves to the block **410,** wherein all the cells of the sector are programmed (in order to guarantee an uniform ageing thereof). In this phase the drain and source select lines of all the strings are brought to the supply voltage **Vdd,** in order to switch on the relative select transistors; moreover, all the bit lines are brought to the voltage 0V, and a blind programming pulse is applied at all the word lines (for example with a value 19V-20V and a time duration of about 10µs).

The block **410** is followed by the block **415,** wherein all the cells of the sector are erased by means of a blind erasing pulse. In particular, the selected word lines are brought to the voltage 0V (while the other word lines are left floating); moreover, a voltage pulse is applied to the body region, for example, with a ramp pattern that starting from 0V reaches 19V in 800µs, and then remains constant for a period typically equal to 200µs. In such a way, the threshold voltage of each cell should be brought under the reading voltage **V_{R}** (OV).

Then, the method **400** moves to the block **420** wherein the sector is read with respect to a reference guard voltage **Vga** equal to the reading voltage with a negative margin (for example, -1V). For this purpose, the same operations described in the following are reiterated for each block of cells of the sector; the block consists of the strings connected to the selected bit lines, which are associated with the pair of select lines identified by the provided address. Particularly, the drain and source select lines of the block are brought to the supply voltage **Vdd** and all the word lines of the block are brought to the reading voltage **V_{R}** (OV).

However, the reading operation is performed with a shorter evaluation time **Teg,** which corresponds to the time that a generic cell having a threshold voltage equal to the guard voltage **Vga** spends for discharging the corresponding bit line from the voltage **Vc** (2.1V) to the comparing voltage **Vref** (1.3V).

In such a way, as described above, at the end of the evaluation time **Teg,** the voltage at the bit line of each string will be higher than the comparing voltage **Vref** if the threshold voltages of all its cells are higher than the guard voltage **Vga** and it will be lower in the opposite case; this allows discriminating such strings with respect to the guard voltage **Vga** on the basis of the read logic level ("1" or "0", respectively).

It should be noted that by using the evaluation time **Teg** it is not necessary a negative decoding (for driving the selected word lines to the guard voltage **Vga**). This allows using a decoding system of only positive (or null) voltages, with a reduced area occupation on the chip.

Then, the method **400** moves to the block **425,** wherein it verifies if all the cells of the sector are erased (with respect to the guard voltage **Vga**).

If at least one cell is not erased *(i.e.,* at least one low logic level has been read in the preceding step), the sector is set as failed at the block **430;** vice versa the method **400** enters a loop, which starts at the block **435,** wherein a soft programming pulse is applied to all the cells of the sector; for example, such pulse has a time duration of 10µs and a value of 13V-14V. As a result, the distribution of the threshold voltages of the erased cells shifts to higher values (as better described in the following).

Successively, at the block **440** each block of the sector is again read with respect to the reference guard voltage **Vga.** The operations at the block **440** are the same of the above described operations at the block **420.**

Then, the method **400** verifies at the block **445** if all the cells of the sector are still erased (with respect to the guard voltage **Vga**). If so (*i.e.,* all high logic levels have been read in the preceding steps) the method **400** returns to the block **435** for repeating the above described operations. In particular, for each loop the programming pulse is increased of a fixed amount (for example, 50 mV). Vice versa, when the result at the block **445** is negative (*i.e*., at least one low logic level has been read), the method **400** moves to the block **450.** In this phase, each block of the sector is read with respect to a higher reference guard voltage **Vgb** (for example, **Vgb=-**0.5V), which is equal to the reading voltage **V_{R}** with a smaller negative margin than the one of the guard voltage **Vga.** As in the preceding case, the select lines of the block are brought to the supply voltage Vdd and the same evaluation time **Teg** is used. In this case, however, the word lines of the block are brought to a biasing voltage **V_{B}** that is shifted according to the difference between the guard voltages **Vgb** and **Vga,** *i.e*., **V_{B} = V_{R} + (Vgb-Vga)** = 0-0.5+1=0.5; in this way, the reading with respect to the higher guard voltage (**Vgb**) is emulated without the need of changing the evaluation time (**Teg**).

Then, the method **400** verifies at the block **455** if all the cells of the sector are still erased (with respect to the guard voltage **Vgb**). If such result is negative (*i.e*., at least one low logic level has been read in the preceding step), the sector is set as failed at the block **430** and the method **400** reaches the end at the block **460.** Vice versa, the method **400** reaches the end at the block **460** directly.

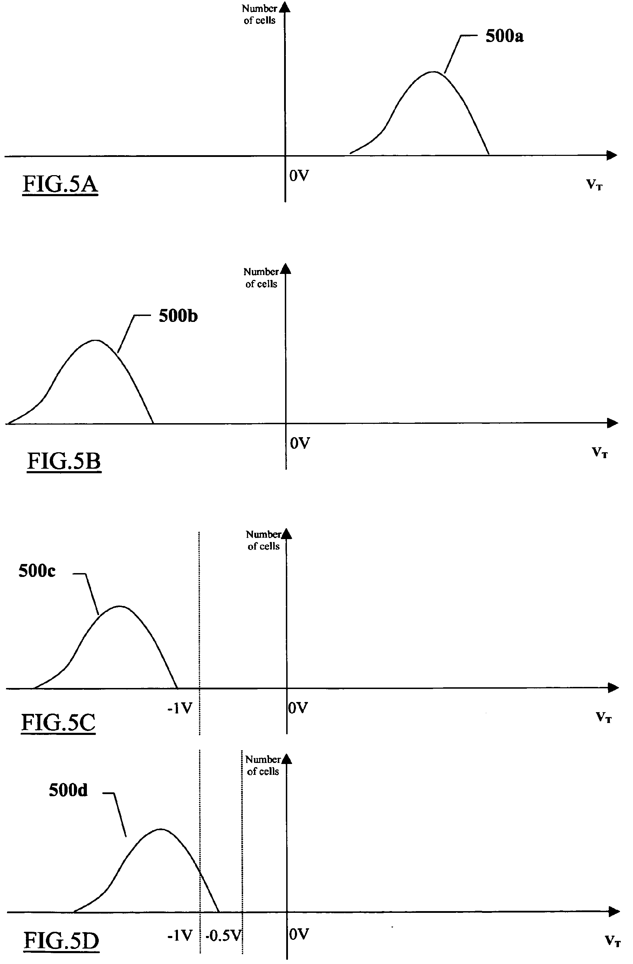

Finally, referring now to **Figures 4** and **5A****-5D** together, a schematic representation of the distribution of the threshold voltages (**V_{T}**) of the cells of the sector at each step of the method **400** is shown. In particular, the **Figures 5A** and **5B** show the distribution **500a** and **500b** of the threshold voltages after the programming operation performed at the block **410** (**V_{T} > V_{R}=**0) and the erase operation performed at the block **415** (**V_{T}** < **V_{R}**=0), respectively. The **Figure 5C** shows a possible distribution of the threshold voltages **500c** after one or more soft-programming operations performed at the block **435.** As can be seen, the distribution **500c** shifts to the right (at every iteration of the loop **435-445**). As shown in **Figure 5D****,** the loop **435-445** ends when the distribution of the threshold voltages during the erase verify operation performed at the block **445** (denoted with **500d**) reaches the guard voltage **Vga** (-1V). In the example at issue, the distribution **500d** does not reach the higher guard voltage **Vgb** (-0.5V), so that the next (soft) erase verify operation performed at the block **450** will be successful.

Naturally, in order to satisfy local and specific requirements, a person skilled in the art may apply to the solution described above many modifications and alterations. Particularly, although the present invention has been described with a certain degree of particularity with reference to preferred embodiments thereof, it should be understood that various omissions, substitutions and changes in the form and details as well as other embodiments are possible; moreover, it is expressly intended that specific elements and/or method steps described in connection with any disclosed embodiment of the invention may be incorporated in any other embodiment as a general matter of design choice.

For example, similar considerations apply if the memory device has a different structure or includes equivalent components. Likewise, the concepts of the present invention find equal application with any other structure of the page buffer (or with equivalent means for reading selected cells of the memory device).

Moreover, it is also possible to increase the evaluation time for emulating a higher reference voltage.

In any case, nothing prevents biasing the selected word lines with voltages having any other values.

It should be readily apparent that the reading of the selected cells with respect to the guard voltage of -0.5V may be achieved by using a corresponding further evaluation time (instead of increasing the biasing voltage of the word lines).

Similar considerations apply if the memory device implements a negative decoding system (and the proposed solution is used for reading the selected cells with respect to positive reference voltages). In any case, nothing prevents the use of the same solution also for emulating reference voltages of the same sign.

The values of the reading voltage and of the guard voltages are merely illustrative; moreover, the implementation of the same solution for reading the selected cells with respect to any other reference voltages is contemplated.

It should be noted that although in the preceding description reference has been made to a specific shifting procedure, this is not to be intended in a limitative manner. For example, it is possible to perform the same operations at the level of pages (instead of strings) so as to have an increased accuracy (at the cost of a longer time); alternatively, it is possible to soft-program and verify every block of cells individually (further increasing the accuracy of the result but with an additional waste of time caused by the continual switches between the programming mode and the reading mode of the memory device). In any case, the application of the proposed solution to other operations different from the erase verify is not excluded (for example, during a program verify operation).

Moreover, the soft erase verify operation at the end of the shifting is not strictly necessary and it may be omitted in a simplified implementation (even if this involves the risk of having cells that are not erased any longer at the end of the procedure).

Although the solution of the invention has been specifically designed for NAND flash memory devices, it is also suitable to be implemented in other memory devices such as Dynamic Random Access Memories (DRAM), Static Random Access Memories (SRAM), NOR flash memory devices, phase-change EEPROMs, multi-level memory devices, and the like.

## Claims

1. A non-volatile memory device (**100**) including a plurality of memory cells (**110**) each one having a programmable threshold voltage, and means for reading **(130, 140, 150)** a set of selected memory cells for comparing the threshold voltages of the selected memory cells with a plurality of reference voltages, for each selected memory cell the means for reading including means for charging (**Pc**) a reading node (**BL**) associated with the selected memory cell with a charging voltage (**Vc**), means for biasing (**130**) the selected memory cell with a biasing voltage, means for connecting (**120d**,**120s**) the charged reading node with the biased selected memory cell, and means for sensing (**220**) a voltage at the reading node at the end of a predefined delay from the connection, wherein for comparing the threshold voltage of the selected memory cell with at least a first one of the reference voltages the biasing voltage is a first biasing voltage equal to the first reference voltage, and the delay is a first delay (**Te**)
**characterized in that**
for comparing the threshold voltage of the selected memory cell with at least a second one of the reference voltages the biasing voltage is a second biasing voltage different from the second reference voltage, and the delay is a second delay different from the first delay.

2. The memory device (**100**) according to claim 1, wherein the second delay is shorter than the first delay (**Te**).

3. The memory device (**100**) according to any one of the preceding claims, wherein the second biasing voltage is equal to the first reference voltage.

4. The memory device (**100**) according to any one of the preceding claims, wherein for comparing the threshold voltage of the selected memory cell with at least a third one of the reference voltages the biasing voltage is a third biasing voltage different from the second biasing voltage, and the delay is a third delay equal to the second delay.

5. The memory device (**100**) according to any one of the preceding claims, wherein each biasing voltage has a first sign or a null value, and wherein the second and/or the third reference voltage has a second sign opposite to the first sign.

6. The memory device (**100**) according to any one of the preceding claims, wherein the first reference voltage is a reading voltage, the second reference voltage is the reading voltage with a margin and the third reference voltage is the reading voltage with a further margin lower than said margin.

7. The memory device (**100**) according to claim 6, wherein the memory cells are arranged in at least one sector (**115**), the memory device further including means for erasing (**415**) all the memory cells of a selected sector and means for shifting (**435-450**) the threshold voltages of the erased memory cells towards the reading voltage, the means for shifting including means for soft-programming (**435**) the memory cells of the selected sector, means for detecting (**440**) an ending condition of the soft-programming according to a result of the reading of the cells of the selected sector with respect to the second reference voltage, and means for stopping (**445**) the soft-programming in response to the ending condition.

8. The memory device (**100**) according to claim 7, wherein the means for shifting (**435**- **450**) further includes means for verifying the erasure (**450**) of the soft-programmed cells according to a result of the reading of the soft-programmed cells with respect to the third reference voltage.

9. The memory device (**100**) according to any one of the preceding claims, wherein the memory device is of the NAND type.

10. A method for reading a non-volatile memory device (**100**) including a plurality of memory cells (**110**) each one having a programmable threshold voltage, the method including the steps of
reading **(130, 140)** a set of selected memory cells by comparing the threshold voltages of the selected memory cells with a plurality of reference voltages, wherein for each selected cell the step of reading includes:
charging (**Pc**) a reading node (**BL**) associated with the selected memory cell with a charging voltage (**Vc**),
biasing (**130**) the selected memory cell with a biasing voltage,
connecting (**120d**, **120s**) the charged reading node with the biased selected memory cell, and
sensing (**220**) a voltage at the reading node (**BL**) at the end of a predefined delay from the connection, wherein
for comparing the threshold voltage of the selected memory cell with at least a first one of the reference voltages the biasing voltage is a first biasing voltage equal to the first reference voltage, and the delay is a common first delay (**Te**)
**characterized in that**
for comparing the threshold voltage of the selected memory cell with at least a second one of the reference voltages the biasing voltage is a second biasing voltage different from the second reference voltage, and the delay is a second delay different from the first delay.

## Patentansprüche

1. Nichtflüchtige Speichervorrichtung (100) mit einer Mehrzahl von Speicherzellen (110), von denen jede eine programmierbare Schwellenspannung hat, und mit einer Leseeinrichtung (130, 140, 150) zum Lesen eines Sets von ausgewählten Speicherzellen zum Vergleichen der Schwellenspannungen der ausgewählten Speicherzellen mit einer Mehrzahl von Referenzspannungen, wobei für jede ausgewählte Speicherzelle die Leseeinrichtung eine Ladeeinrichtung (Pc) zum Laden eines der ausgewählten Speicherzelle zugeordneten Lese-Knotens (BL) mit einer Vorspannnung, eine Vorspanneinrichtung (130) zum Vorspannen der ausgewählten Speicherzelle mit einer Vorspannung, eine Verbindungseinrichtung (120d, 120s) zum Verbinden des geladenen Lese-Knotens mit der vorgespannten ausgewählten Speicherzelle, sowie eine Erfassungseinrichtung (220) zum Erfassen einer Spannung an dem Lese-Knoten an dem Ende einer vorbestimmten Verzögerung von der Verbindung aufweist, wobei zum Vergleichen der Schwellenspannung der ausgewählten Speicherzelle mit mindestens einer ersten der Referenzspannungen die Vorspannung eine erste Vorspannung ist, die gleich der ersten Referenzspannung ist und die Verzögerung eine erste Verzögerung (Te) ist,
**dadurch gekennzeichnet, dass** zum Vergleichen der Schwellenspannung der ausgewählten Speicherzelle mit mindestens einer zweiten der Referenzspannungen die Vorspannung eine von der zweiten Referenzspannung verschiedene, zweite Vorspannung ist und die Verzögerung eine von der ersten Verzögerung verschiedene, zweite Verzögerung ist.

2. Speichervorrichtung (100) nach Anspruch 1,
wobei die zweite Verzögerung kürzer als die erste Verzögerung (Te) ist.

3. Speichervorrichtung (100) nach einem der vorausgehenden Ansprüche,
wobei die zweite Vorspannung gleich der ersten Referenzspannung ist.

4. Speichervorrichtung (100) nach einem der vorausgehenden Ansprüche,
wobei zum Vergleichen der Schwellenspannung der ausgewählten Speicherzelle mit mindestens einer dritten der Referenzspannungen die Vorspannung eine von der zweiten Vorspannung verschiedene, dritte Vorspannung ist und die Verzögerung eine dritte Verzögerung gleich der zweiten Verzögerung ist.

5. Speichervorrichtung (100) nach einem der vorausgehenden Ansprüche,
wobei jede Vorspannung ein erstes Vorzeichen oder einen Null-Wert hat und wobei die zweite und/oder die dritte Referenzspannung ein zweites Vorzeichen hat, das zu dem ersten Vorzeichen entgegengesetzt ist.

6. Speichervorrichtung (100) nach einem der vorausgehenden Ansprüche,
wobei die erste Referenzspannung eine Lesespannung ist, die zweite Referenzspannung die Lesespannung mit einem Toleranzbereich ist und die dritte Referenzspannung die Lesespannung mit einem weiteren Toleranzbereich ist, der niedriger ist als der genannte Toleranzbereich.

7. Speichervorrichtung (100) nach Anspruch 6,
wobei die Speicherzellen in mindestens einem Sektor (115) angeordnet sind, wobei die Speichervorrichtung ferner eine Löscheinrichtung (415) zum Löschen von allen Speicherzellen eines ausgewählten Sektors sowie eine Verschiebeeinrichtung (435 - 450) zum Verschieben der Schwellenspannungen der gelöschten Speicherzellen in Richtung der Lesespannung aufweist, wobei die Verschiebeeinrichtung eine Softprogrammiereinrichtung (435) zum Softprogrammieren der Speicherzellen des ausgewählten Sektors, eine Detektionseinrichtung (440) zum Detektieren einer Ende-Bedingung der Softprogrammierung in Abhängigkeit von einem Resultat des Lesens der Zellen des ausgewählten Sektors in Bezug auf die zweite Referenzspannung sowie eine Stoppeinrichtung (445) zum Stoppen der Softprogrammierung nach Maßgabe der Ende-Bedingung aufweist.

8. Speichervorrichtung (100) nach Anspruch 7,
wobei die Verschiebeeinrichtung (435 - 450) ferner eine Einrichtung zum Verifizieren des Löschens (450) der softprogrammierten Zellen in Abhängigkeit von einem Resultat des Lesens der softprogrammierten Zellen in Bezug auf die dritte Referenzspannung aufweist.

9. Speichervorrichtung (100) nach einem der vorausgehenden Ansprüche,
wobei es sich bei der Speichervorrichtung um eine des NAND-Typs handelt.

10. Verfahren zum Lesen einer nichtflüchtigen Speichervorrichtung (100), die eine Mehrzahl von Speicherzellen (110) aufweist, von denen jede eine programmierbare Schwellenspannung hat,
wobei das Verfahren folgende Schritte beinhaltet:
Lesen (130, 140) eines Sets von ausgewählten Speicherzellen durch Vergleichen der Schwellenspannungen der ausgewählten Speicherzellen mit einer Mehrzahl von Referenzspannungen, wobei für jede ausgewählte Zelle der Leseschritt Folgendes beinhaltet:
Laden (Pc) eines der ausgewählten Speicherzelle zugeordneten Lese-Knotens (BL) mit einer Ladespannung (Vc),
Vorspannen (130) der ausgewählten Speicherzelle mit einer Vorspannung, und
Verbinden (120d, 120s) des geladenen Lese-Knotens mit der vorgespannten ausgewählten Speicherzelle, und
Erfassen (220) einer Spannung an dem Lese-Knoten (BL) an dem Ende einer vorbestimmten Verzögerung von der Verbindung,
wobei zum Vergleichen der Schwellenspannung des ausgewählten Speicherzelle mit mindestens einer ersten der Referenzspannungen die Vorspannung eine erste Vorspannung ist, die gleich der ersten Referenzspannung ist, und die Verzögerung eine gemeinsame erste Verzögerung (Te) ist,
**dadurch gekennzeichnet, dass** zum Vergleichen der Schwellenspannung der ausgewählten Speicherzelle mit mindestens einer zweiten der Referenzspannungen die Vorspannung eine von der zweiten Referenzspannung verschiedene, zweite Vorspannung ist und die Verzögerung eine von der ersten Verzögerung verschiedene, zweite Verzögerung ist.

## Revendications

1. Dispositif de mémoire non volatile (100) incluant une pluralité de cellules mémoire (110) dont chacune a une tension de seuil programmable, et des moyens (130, 140, 150) pour lire un ensemble de cellules mémoire sélectionnées pour comparer les tensions de seuil des cellules mémoire sélectionnées à une pluralité de tensions de référence, les moyens de lecture incluant, pour chaque cellule mémoire sélectionnée, des moyens de charge (Pc) d'un noeud de lecture (BL) associé à la cellule mémoire sélectionnée par une tension de charge (Vc), des moyens (130) pour polariser la cellule mémoire sélectionnée par une tension de polarisation, des moyens (120d, 120s) pour connecter le noeud de lecture chargé à la cellule mémoire sélectionnée polarisée, et des moyens (220) pour lire la tension sur le noeud de lecture à la fin d'un retard prédéterminé après la connexion, dans lequel, pour comparer la tension de seuil de la cellule mémoire sélectionnée à au moins une première des tensions de référence, la tension de polarisation est une première tension de polarisation égale à la première tension de référence et le retard est un premier retard (Te) ;
**caractérisé en ce que** pour comparer la tension de seuil de la cellule mémoire sélectionnée à au moins une deuxième des tensions de référence, la tension de polarisation est une deuxième tension de polarisation distincte de la deuxième tension de référence et le retard est un second retard distinct du premier retard.

2. Dispositif de mémoire (100) selon la revendication 1, dans lequel le second retard est plus court que le premier retard (Te).

3. Dispositif de mémoire (100) selon l'une quelconque des revendications précédentes, dans lequel la deuxième tension de polarisation est égale à la première tension de référence.

4. Dispositif de mémoire (100) selon l'une quelconque des revendications précédentes, dans lequel, pour comparer la tension de seuil de la cellule mémoire sélectionnée à au moins une troisième des tensions de référence, la tension de polarisation est une troisième tension de polarisation distincte de la deuxième tension de polarisation et le retard est un troisième retard égal au second retard.

5. Dispositif de mémoire (100) selon l'une quelconque des revendications précédentes, dans lequel chaque tension de polarisation a un premier signe ou une valeur nulle et dans lequel la deuxième et/ou la troisième tension de référence a un second signe opposé au premier signe.

6. Dispositif de mémoire (100) selon l'une quelconque des revendications précédentes, dans lequel la première tension de référence est une tension de lecture, la deuxième tension de référence est la tension de lecture avec une marge et la troisième tension de référence est la tension de lecture avec une autre marge inférieure à ladite marge.

7. Dispositif de mémoire (100) selon la revendication 6, dans lequel les cellules mémoire sont disposées en au moins un secteur (115), le dispositif de mémoire comprenant en outre des moyens (415) pour effacer toutes les cellules mémoire d'un secteur sélectionné et des moyens (435-450) pour décaler les tensions de seuil des cellules mémoire effacées vers la tension de lecture, les moyens de décalage incluant des moyens de programmation (435) des cellules mémoire du secteur sélectionné, des moyens (440) pour détecter une condition de fin de programmation selon le résultat de la lecture des cellules du secteur sélectionné par rapport à la deuxième tension de référence, et des moyens (445) pour arrêter la programmation en réponse à la condition de fin.

8. Dispositif de mémoire (100) selon la revendication 7, dans lequel les moyens de décalage (435-450) comprennent en outre des moyens (450) pour vérifier l'effacement des cellules programmées selon le résultat de la lecture des cellules programmées par rapport à la troisième tension de référence.

9. Dispositif de mémoire (100) selon l'une quelconque des revendications précédentes, dans lequel le dispositif mémoire est du type NON ET.

10. Procédé de lecture d'un dispositif de mémoire non volatile (100) incluant une pluralité de cellules mémoire (110) dont chacune a une tension de seuil programmable, comprenant les étapes suivantes:
lire (130, 140) un ensemble de cellules mémoire sélectionnées en comparant les tensions de seuil des cellules mémoire sélectionnées à une pluralité de tensions de référence, l'étape de lecture incluant pour chaque cellule mémoire sélectionnée :
charger (Pc) un noeud de lecture (BL) associé à la cellule mémoire sélectionnée par une tension de charge (Vc),
polariser (130) la cellule mémoire sélectionnée par une tension de polarisation,
connecter (120d, 120s) le noeud de lecture chargé à la cellule mémoire sélectionnée polarisée, et
lire (220) la tension sur le noeud de lecture (BL) à la fin d'un retard prédéterminé après la connexion,
dans lequel, pour comparer la tension de seuil de la cellule mémoire sélectionnée à au moins une première des tensions de référence, la tension de polarisation est une première tension de polarisation égale à la première tension de référence et le retard est un premier retard commun (Te) ;
**caractérisé en ce que**, pour comparer la tension de seuil de la cellule mémoire sélectionnée à au moins une deuxième des tensions de référence, la tension de polarisation est une deuxième tension de polarisation distincte de la deuxième tension de référence et le retard est un second retard distinct du premier retard.
